# NEW EUROPEAN PATENT SPECIFICATION

(11) **EP 0 130 844 B2**
(45) Date of publication and mention of the opposition decision: **03.09.1997**
(45) Mention of the grant of the patent: 27.09.1989
(21) Application number: 84304576.6
(22) Date of filing: 04.07.1984
(51) Int. Cl.: H01R 23/68, H05K 7/02, H01R 13/66, H05K 3/30

(54) **Interconnection apparatus for wiring harnesses**
Zwischenverbindungseinrichtung für Kabelbäume
Dispositif pour des connexions intermédiaires pour des peignes de câbles

(30) Priority: 05.07.1983 JP 122640/83; 05.07.1983 JP 122641/83
(43) Date of publication of application: 09.01.1985
(73) Proprietor: Sumitomo Wiring Systems, Ltd., Yokkaichi-shi Mie-ken (JP); SUMITOMO ELECTRIC INDUSTRIES LIMITED, Osaka-shi, Osaka 541 (JP)
(72) Inventor: ITO, Mitsuru, Kuwana-shi (JP)
(74) Representative: Thomas, Roger Tamlyn

(56) References cited:
- DE-A- 1 615 596
- DE-A- 2 409 660
- DE-A- 2 641 258
- DE-A- 2 821 992
- DE-U- 7 224 479
- DE-U- 7 327 573
- DE-U- 8 032 049
- US-A- 3 963 301
- US-A- 4 133 592
- US-A- 4 218 724

## Description

The present invention relates to improvements in and relating to an interconnection apparatus for wiring harnesses particularly those in which a large number of branch conductive paths are formed by the arrangement of a busbar and are connected to the cables of a wiring harness to construct desired branch circuits.

Wiring harnesses heretofore used for the interior wiring of automobiles require a large number of branch circuits in the midst of the wiring harness and an interconnection apparatus for wiring harnesses (hereinafter simply referred to as an interconnection apparatus) is known in the art in which the corresponding branch conductive paths to the branch circuits of the wiring harness are concentrically formed on a wiring board by the arrangement of a busbar and the cables of the wiring harness are connected to the branch conductive paths thereby concentrically constructing the desired branch circuits. However in order to ensure the functioning of these branch circuits, e.g., a flasher relay, etc., it is necessary that the control element, e.g. a relay and functional components such as diodes and capacitors required for each branch circuit, are arranged, and their electronic circuit is incorporated, in the branch circuit. Thus, there is a marked tendency toward further increasing the complexity of such electronic circuits.

In order to make the interconnection apparatus having these tendencies more compact and smaller in size, the applicant has proposed in Japanese Patent Application No. 57-194851, (Laid Open No. 59-83374), a novel interconnection apparatus comprising in combination a wiring board including the desired branch conductive path group formed by the arrangement of a busbar and a plurality of printed-circuit boards having concentrically and densely arranged thereon the required functional component group for the branch circuit group of a wiring harness whereby the printed-circuit boards are detachably mounted on the wiring board and the terminals provided at the side edges of the printed-circuit boards are cdnnected to the ends of the busbar of the wiring board thereby incorporating and connecting the functional component circuits of the printed-circuit boards to the branch conductive paths.

An interconnection apparatus according to the pre-characterising part of claim 1 is described in US-A-4218724.

According to the present invention, there is provided an interconnection apparatus for wiring harnesses comprising:
a wiring board comprising a single-layer insulating board;
a cover extending over the insulating board to cover the same;
branch conductive path means formed by a busbar comprising a portion defining a conductive path on the front surface of the insulating board, and having a predetermined pattern;
functional component circuit means formed by a plurality of functional components mounted on the front of the insulating board;
printed wiring circuit means interconnecting said busbar and said functional components; and
a plurality of tab contact members which project from the front surface of said insulating board and which, in use of the apparatus, are connected to branch circuit means of a wiring harness;
characterised in that:
said busbar further comprises at least two said tab contact members formed integrally with said portion, and a downwardly projecting conductive mounting piece formed integrally with said portion and extending through a mounting hole of the insulating board; and
said printed wiring circuit means is provided on the back of the insulating board.

An embodiment of the present invention enables one to make smaller and more compact an interconnection apparatus of the type including simple circuitry and functional component assembly for two-wheeled vehicles, for example.

More specifically, the present invention permits a novel construction in which a busbar pattern including branch conductive paths formed by the arrangement of a busbar and a printed-wiring pattern including a functional component group arranged densely, and its functional components circuits formed by printed wiring, are formed on a single-layer insulating board thereby incorporating and connecting the functional component circuits in the branch conductive paths.

Thus, the desired branch conductive path group and functional component circuits are formed on a single-layer insulating board and are interconnected thereby making the interconnection apparatus considerably smaller and more compact than previously.

An embodiment of the invention will now be described, by way of example, with reference to the accompanying drawings, in which:
Figure 1 is a perspective view showing an interconnection apparatus according to an embodiment of the invention;
Figure 2 is a plan view of the back of the wiring board in the embodiment of Figure 1;
Figures 3 and 4 are front sectional views showing respectively the coupling of the busbar and the insulating board and the connection of the busbar and the printed conductive path in Figure 1;
Figure 5 is a front sectional view showing the manner in which the tab terminals are mounted; and
Figures 6 and 7 are front sectional views showing the function of the press peices in the embodiment of Figure 1.

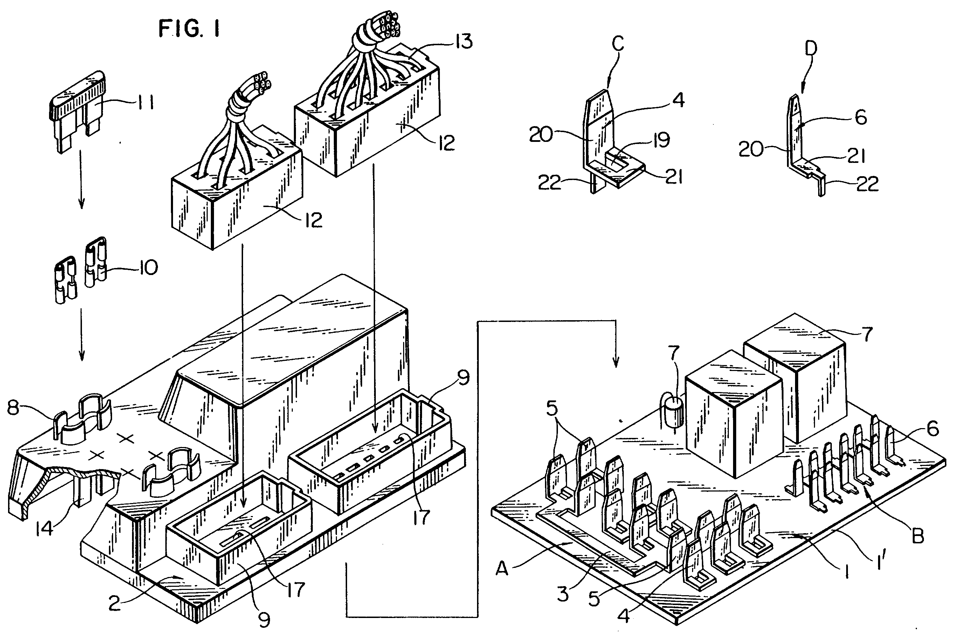

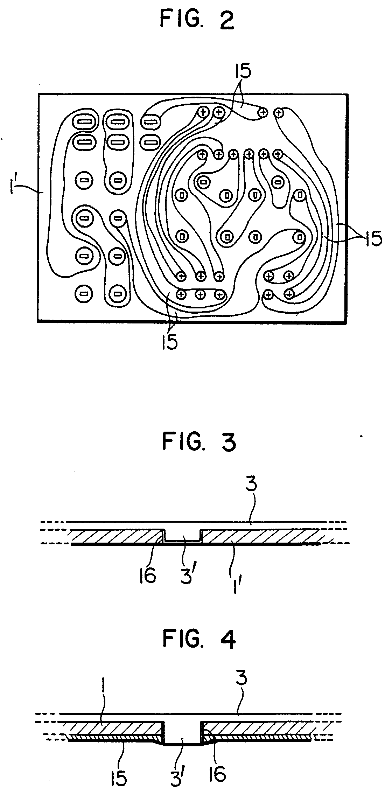

The present inveniton will now be described in a greater detail with reference to an embodiment of the invention. Referring to Figs. 1 to 7 which show this embodiment, an interconnection apparatus of the invention includes a wiring board 1 comprising a single-layer insulating board 1' and a cover 2 placed over the wiring board 1. In Fig. 1, the left hand part of the wiring board 1 includes a busbar pattern A including the desired branch conductive path group formed by a busbar 3 and the right hand part includes a printed wiring pattern B including a group of functional components 7 arranged densely on the insulating board 1' and printed conductive paths 15 (see Fig. 2) on the back forming the circuits of the functional components 7 by printed wiring. More specifically the busbar 3 of the busbar pattern A forms the desired branch conductive paths on the single-layer insulating board 1' and the busbar 3 is provided with downwardly projected mounting pieces 3' which are fitted in mounting holes 16 of the insulating board 1' for positioning the busbar 3 and tab contact members 5 vertically arranged at its end portions. After the mounting of the cover 2 which will be described later, a fuse 11 is fitted on the tab contact members 5 through intermediate terminals 10 and connectors 12 at the end of bundles of cables 13 are fitted on the tab contact members 5.

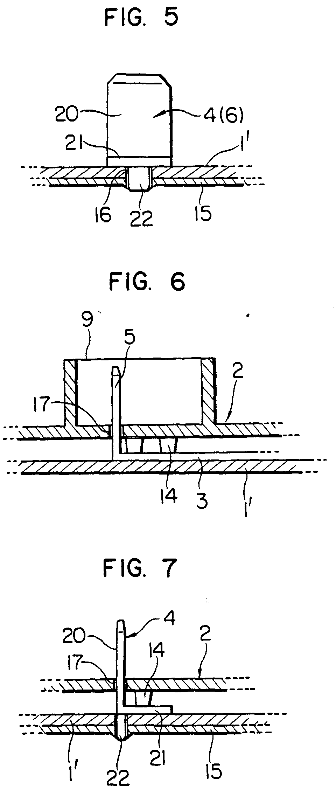

The printed wiring pattern B includes tab terminals 4 and 6 arranged vertically on the insulating board 1' and connected to the printed conductive paths 15 on the back of the insulating board 1' and the tab terminals 4 and 6 are adapted for connection with the connectors 12 to incorporate and connect the functional component circuits provided by the printed conductive paths 15 in the branch circuits of a wiring harness. On the other hand, the printed conductive paths 15 of the functional components 7 associated for example with the fuse are connected to the busbar 3 so that the functional component circuits provided by the printed conductive paths 15 are incorporated and connected to the branch conductive paths of the busbar 3. More specifically, as shown at C in Fig. 1, each tab terminal 4 includes a plate base portion 21, a tab contact portion 20 formed by bending one end of the base portion 21 through 90°, a window 19 cut out of the base portion 21 and a conductive piece 22 provided by forming the cutout material into a leg shape. Also, as shown at D in Fig. 1, each tab terminal 6 includes a plate base portion 21, a tab contact portion 20 and a leg conductive piece 22 which is formed by bending the end of the base portion 21 in the opposite direction through 90°. Each tab terminal 4 or 6 is vertically arranged on the wiring board 1 and the conductive piece 22 is fitted into the mounting hole 16 of the insulating board 1 and soldered at its forward end to the printed conductive path 15 on the back of the insulating board 1' as shown in Fig. 5.

The busbar 3 is connected to the printed conductive paths 15 by inserting the mounting pieces 3' projecting downwardly from the side edges of the busbar 3 into the mounting holes 16 of the insulating board 1' and soldering the forward ends of the mounting pieces 3' to the printed conductive paths 15 as shown in Fig. 4.

The cover 2 which is placed over the above-mentioned wiring board 1, is made of a thin sheet of resin material which is mounted to shield and enclose the busbar 3 and the functional components 7 on the wiring board 1 and thereby insulate and protect them. Arranged on the upper surface of the cover 2 are fuse mounts 8 and connector mounts 9 in frame form and the connector mounts 9 are provided with holes 17 through which are inserted the tab contact portions 5 and the tab contact portions 20 of the tab terminals 4 and 6. Also, a large number of press pieces 14 are arranged at suitable positions on the inner side of the cover 2 so that when the cover 2 is mounted on the wiring board 1, each of the press pieces 14 contacts and presses from above the busbar against the base of a tab contact member 5 or the base portion 21 of a tab terminal 4 or 6 as shown as Fig. 6 or 7. It is to be noted that the cover 2 is adapted to cover the wiring board 1 so as to accommodate its peripheral edges and it is provided, though not shown, with locking pawls or the like on the inner side of the peripheral edges so as to lock the cover 2 in its mounted position and thereby prevent it from being removed easily. Also, if necessary, the cover 2 is provided with a locking mechanism which locks and unlocks the cover 2 as desired.

In use of the interconnection apparatus of this invention constructed as described above, after the cover 2 has been mounted, locked and assembled to the wiring board 1, the fuse 11 is fitted in the fose mount 8 through the intermediate terminals 10 and the connectors 12 are connected to the connector mounts 9 thereby forming the desired branch circuit group in the midst of the wiring harness and incorporating and connecting the required functional component circuits in the respective branch circuits.

As described hereinabove, by virtue of the fact that both the busbar pattern A and the printed wiring pattern B are formed on the same single-layer insulating board 1' and the busbar pattern A and the printed wiring pattern B are interconnected without each requiring such mechanical contact means as terminals, intermediate terminals, etc., the apparatus is greatly reduced in size, made considerably more compact and greatly reduced in weight. By making the apparatus so compact, it is possible to reduce the number of component parts and thereby reduce the cost and improve the quality, reliability, etc.

Further, by virtue of the fact that the apparatus includes the press pieces 14 and the tab terminals 4 and 6 which are designed as mentioned previously and the mounting of the cover 2 on the wiring board 1 causes the press pieces 14 to press down the busbar 3 forming the bars of the tab contact members 5 and the base portions 21 of the tab terminals 4 and 6, when the connectors 12 and the fuse 11 fitted on the tab contacts 5 and 20 are removed, the external force due to the removing resistance is borne by the cover 2 which is locked to the wiring board 1 and thus there is no danger of any undesired external force being borne by the tab contact members 5 and the conductive pieces 22 of the tab terminals 4 and 6. As a result, there is no danger of deforming the tab contact members 5 and causing derangement of the busbar 3 and there is no danger of causing damage to the soldered portions of the conductive pieces 22 of the tab terminals 4 and 6 so that their current conducting performance is maintained.

From the foregoing description it will be seen that both the branch circuits and the functional component circuits are so simplified and made compact that they are well suited for use for example with two-wheeled vehicles.

## Claims

1. An interconnection apparatus for wiring harnesses comprising:
a wiring board (1) comprising a single-layer insulating board (1');
a cover (2) extending over the insulating board (1') to cover the same;
branch conductive path means formed by a busbar (3) comprising a portion defining a conductive path on the front surface of the insulating board (1'), and having a predetermined pattern (A);
functional component circuit means formed by a plurality of functional components (7) mounted on the front of the insulating board (1');
printed wiring circuit means (15) interconnecting said busbar (3) and said functional components (7); and
a plurality of tab contact members (5) which project from the front surface of said insulating board and which, in use of the apparatus, are connected to branch circuit means of a wiring harness;
characterised in that:
said busbar (3) further comprises at least two said tab contact members (5) formed integrally with said portion, and a downwardly projecting conductive mounting piece (3') formed integrally with said portion and extending through a mounting hole (16) of the insulating board (1'); and
said printed wiring circuit means (15) is provided on the back of the insulating board (1').

2. An apparatus as claimed in claim 1, in which said cover (2) includes a plurality of press pieces (14) disposed so as to be pressed against bottom arms (21) of L-shaped tab contact members (5).

## Patentansprüche

1. Zwischenverbindungseinrichtung für Kabelbäume mit:
einer Schaltungsplatte (1), die eine einschichtige, isolierende Platte (1') enthält,
einer Abdeckung (2), die sich über die isolierende Platte (1') erstreckt, um dieselbe abzudecken,
leitenden Abzweigbahnen, die von einer Schiene (3) gebildet sind, die einen Abschnitt umfaßt, der eine Leiterbahn auf der Vorderfläche der isolierenden Platte bildet, und die ein vorherbestimmtes Muster (A) aufweist,
funktionellen Schaltungskomponenten, die von mehreren auf der Vorderseite der isolierenden Platte (1') angebrachten funktionellen Komponenten (7) gebildet sind,
gedruckten Schaltungen (15), die die Schiene (3) und die funktionellen Komponenten (7) miteinander verbinden, und
mehreren vorspringenden Kontaktgliedern (5), die von der Vorderfläche der isolierenden Platte vorstehen und bei einer Benutzung der Einrichtung mit Abzweigschaltungsmitteln eines Kabelbaumes verbunden sind;
**dadurch gekennzeichnet**, daß die Schiene (3) weiterhin wenigstens zwei der vorspringenden Kontaktglieder (5) umfaßt, die integral mit dem Abschnitt ausgebildet sind, sowie ein nach unten vorstehend angebrachtes leitendes Anbringungsteil (3'), das integral mit dem Abschnitt ausgebildet ist und sich durch ein Anbringungsloch (16) der isolierenden Platte (1') hindurch erstreckt, und
die gedruckten Schaltungen (15) auf der Rückseite der isolierenden Platte (1') vorhanden sind.

2. Einrichtung, wie im Anspruch 1 beansprucht, bei der die Abdeckung (2) mehrere derart angeordnete Preßstücke (14) enthält, daß sie gegen Grundarme (21) L-förmiger, vorspringender Kontaktglieder (5) andrückbar sind.

## Revendications

1. Dispositif d'interconnexion pour des peignes de câbles comprenant :
une carte de câblage (1) comprenant une plaque isolante monocouche (1') ;
un couvercle (2) s'étendant au-dessus de la plaque isolante (1') de manière à la recouvrir ;
des moyens constituant des trajets conducteurs de dérivation, formés par une barre omnibus (3) comprenant une partie définissant un trajet conducteur sur la surface avant de la carte isolante (1') et possédant une configuration prédéterminée (A) ;
des moyens formant circuit de composants fonctionnels, constitués de plusieurs composants fonctionnels (7) montés sur l'avant de la plaque isolante (1') ;
des moyens (15) formant circuit de câblage imprimé raccordant ladite barre omnibus (3) et lesdits composants fonctionnels (7); et
plusieurs éléments de contact en forme de languettes (5) qui s'étendent à partir de la surface avant de la plaque isolante et qui, lors de l'utilisation du dispositif, sont raccordés à des moyens formant circuit de dérivation d'un peigne de câbles ;
caractérisé en ce que ladite barre omnibus (3) comporte en outre deux desdits éléments de contact en forme de languettes (5) formés intégralement avec ladite partie, et un élément de montage (3') conducteur en saillie vers le bas et formé intégralement avec ladite partie, ledit élément s'étendant à travers un trou de montage (16) de la plaque isolante (1'); et
lesdits moyens (15) formant circuit de câblage imprimé étant prévus sur l'arrière de la plaque monocouche (1').

2. Dispositif selon la revendication 1, dans ledit couvercle (2) comporte plusieurs éléments de pression (14) disposés de manière à être appliqués sous pression contre des bras inférieurs (21) des éléments de contact en forme de languettes en L (5).
